(19) Europäisches Patentamt

European Patent Office

Office européen des brevets

(11) EP 2 355 546 A1

(12) EUROPEAN PATENT APPLICATION

(43) Date of publication:
10.08.2011 Bulletin 2011/32

(51) Int Cl.:
H04R 17/00 (2006.01)   H01L 41/04 (2006.01)
G10K 7/00 (2006.01)

(21) Application number: 10152546.7

(22) Date of filing: 03.02.2010

(84) Designated Contracting States:
AT BE BG CH CY CZ DE DK EE ES FI FR GB GR
HR HU IE IS IT LI LT LU LV MC MK MT NL NO PL
PT RO SE SI SK SM TR
Designated Extension States:
AL BA RS

(71) Applicant: Delphi Technologies, Inc.
Troy, Michigan 48007 (US)

(72) Inventor: Typrowicz, Wojciech
38-406 Odrzykon (PL)

(74) Representative: Vigand, Philippe
Novagraaf Switzerland S.A.
Conseils en Propriété Industrielle SA
Avenue de Pailly 25
1220 Les Avanchets-Genève (CH)

(54) **Piezo driver with sound pressure level control**

(57)    The invention relates to an alarm sounder comprising a piezoelectric speaker (20) to generate an alarm sound controlled by a driver comprising a control circuit (22) connected to switching means (S1, S2) for alternatively increasing and decreasing energy across a winding (L1) coupled to the piezoelectric speaker, characterized in that the driver comprises means for stabilizing the piezoelectric voltage ($U_{piezo}$).

Figure 2

**Description**

TECHNICAL FIELD

The present invention relates to an alarm sounder using a piezoelectric speaker to generate the alarm sound. Such an alarm sounder is more particularly used in automotive vehicle.

BACKGROUND OF THE INVENTION

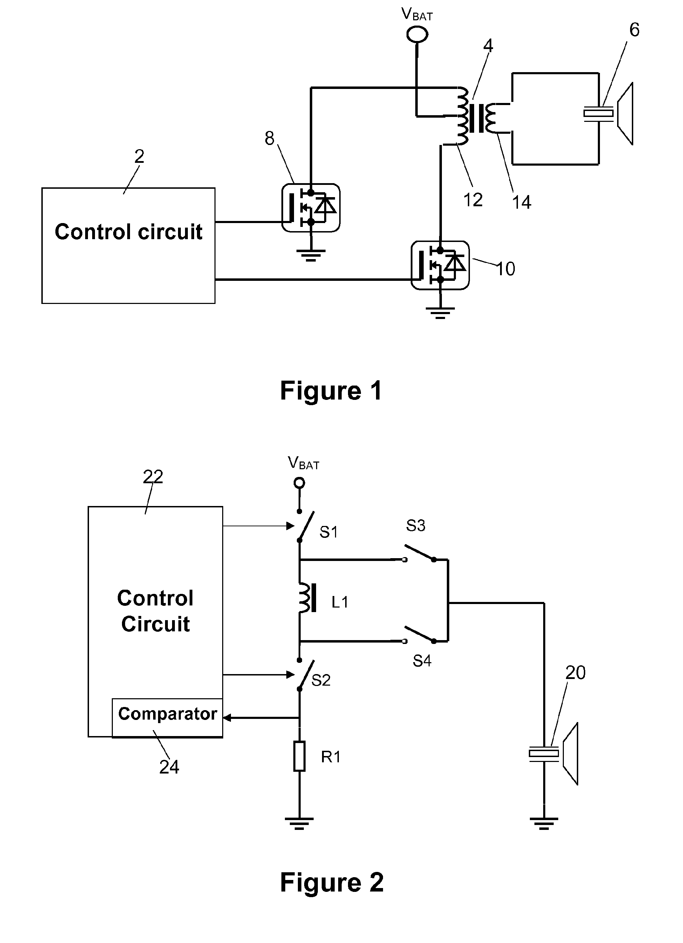

Such an alarm sounder using piezoelectric speaker already exists. Indeed, it is known that the piezoelectric speaker has high efficiency, but it requires high voltage to generate high Sound Pressure Level (SPL). Currently to generate such high voltage the alarm sounders or sirens are using a driver based on a transformer. An example of such a driver is presented on schematic of Figure 1.

The driver comprises a control circuit 2 and a transformer 4 comprising a primary winding 12 on the driver side and on the speaker side a secondary winding 14 connected in parallel with the piezoelectric speaker 6. The control circuit 2 controls a couple of switching means 8 and 10 for alternatively increasing and decreasing voltage across the primary winding 12 and transferring the stored energy to the secondary winding 14 and then to the speaker 6. According to the desired voltage level for energizing the speaker, the supply voltage $V_{BAT}$ is connected to an appropriate portion of the primary winding 12.

This kind of driver requires big and heavy transformer and did not allow to control or stabilize the sound pressure level, because the driver's output voltage is set by the transformer ratio of turns and the supply voltage $V_{BAT}$.

SUMMARY OF THE INVENTION

One goal of the present invention is to overcome the aforecited drawbacks by providing an alarm sounder using a piezoelectric speaker driver with sound pressure level control.

For that purpose, according to a first aspect, the invention concerns an alarm sounder comprising a piezoelectric speaker to generate an alarm sound controlled by a driver comprising a control circuit connected to switching means for alternatively increasing and decreasing energy across a winding coupled to the piezoelectric speaker, characterized in that the driver comprises means for stabilizing the piezoelectric voltage. Stabilization of the piezoelectric voltage allows controlling the sound pressure level.

According to an advantageous embodiment, the means for stabilizing the piezoelectric voltage includes means for limiting the energy stored in the winding to a predefined level and means for transferring said predefined level of energy directly from the winding to the piezoelectric speaker. Such stabilizing means guaranties that energy stored in the winding is predefined, advantageously constant, and independent from the supply voltage. Thus, the driver's output voltage is neither set by the winding ratio of turns nor the supply voltage. Transfer of a predefined portion of energy to the piezoelectric speaker allows stabilization of the piezoelectric voltage and therefore control of its sound pressure level.

According to another advantageous embodiment, the limiting means comprises a comparator which monitors the winding current with a predetermined threshold so as to limit energy storage to the predefined level. Current monitoring allows storing the required portion of energy within the winding. Advantageously, one terminal of the winding is connected to ground through a resistive element and the predetermined threshold is set by the voltage drop across the resistive element and a comparator reference voltage.

According to another advantageous embodiment, the transferring means includes a first, respectively a second, switch connected between one, respectively the other, winding terminals and a same terminal of the piezoelectric speaker, the other terminal of the piezoelectric speaker being connected to ground, and wherein both switches are alternatively switched on and off so as to transfer with opposite direction said predefined level of energy to the piezoelectric speaker.

According to another advantageous embodiment, one winding terminal is connected to the supply voltage through a third switch and the other winding terminal is connected to ground through a fourth switch, the control circuit being adapted for switching on simultaneously both the third and fourth switches to store energy within the winding and for alternatively switching off one of the two switches when the predefined level of energy is stored so as to transfer energy to the piezoelectric speaker.

According to another advantageous embodiment, the driver comprises a couple of windings connected in series and wherein the common terminal of both windings is connected to both terminals of the piezoelectric speaker through two switches and each extreme winding terminal controls one of the two switches so as to be alternatively switched on and off to transfer with opposite direction said predefined level of stored energy in either one or the other of the two inductors to the piezoelectric speaker.

BRIEF DESCRIPTION OF THE DRAWINGS

Other features and advantages of the invention will appear upon reading the following description which refers to the annexed drawings in which:

-   Figure 1, already described, is an electrical schematic illustration of an alarm sounder driver according to the prior art;

-   Figure 2 illustrates a block diagram of an alarm sounder according to a preferred embodiment of the invention;

-   Figure 3 represents a diagram showing the operation of the alarm sounder according to the embodiment of Figure 2;

-   Figure 4 illustrates a detailed electrical schematic of the alarm sounder according to a first variant;

-   Figure 5 illustrates a detailed electrical schematic of the alarm sounder according to a second variant.

DETAILED DESCRIPTION OF THE INVENTION

The basic principle of the invention is to make a universal piezoelectric speaker driver with sound pressure level (SPL) control. With reference now to Figure 2, a preferred embodiment of an alarm sounder according to the invention is shown.

The alarm sounder comprises a piezoelectric speaker 20 able to generate an alarm sound and controlled by a driver comprising a control circuit 22 connected to a couple of switching means S1, S2 for alternatively increasing and decreasing energy across a winding L1 coupled to the piezoelectric speaker 20. One winding terminal $T_1$ is connected to the supply voltage $V_{SAT}$ through switch S1 while the other winding terminal $T_2$ is grounded through switch S2. Preferably a resistive element R1 is connected between switch S2 and ground through in order to determine the threshold of energy to be stored in the winding by the voltage drop across the resistive element. The control circuit 22 is adapted for switching on and off both switches S1 and S2 to store energy within the winding L1.

For stabilizing the piezoelectric voltage, the driver further includes a comparator 24 which monitors the winding current with a predetermined threshold so as to limit energy storage to the predefined level. It furthermore includes a switch S3 connected between terminal $T_1$ of the winding and the driver's output connected to terminal $T_s$ of the speaker 20 and a switch S4 connected between the other terminal $T_2$ of the winding and the driver's output $T_s$ so as to be able to transfer with opposite direction the predefined level of energy to the piezoelectric speaker, which is seen as a capacitance.

The following formulas apply to the alarm sounder driver shown in Figure 2.

$$\text{Energy stored in winding:} \qquad E = 0{,}5 * L * I^2 \qquad\qquad (1)$$

$$\text{Energy stored in capacitor:} \qquad E = 0{,}5 * C_{piezo} * U_{piezo}^2 \qquad\qquad (2)$$

$$\text{Voltage across piezoelectric:} \qquad U_{piezo} = I * sqrt(L/C_{piezo}) \qquad\qquad (3)$$

During operation the winding current is monitored by the comparator 24 and is always switched off at the same threshold based on equation (1) which guaranties that the energy stored in winding is constant and independent of the supply voltage. Thus when the winding energy is constant then the piezoelectric speaker voltage is also constant which is derivable from equation (3). The comparator threshold can be set by the controller circuit so that the sound pressure level (SPL) may be changed as needed; e.g. end of line calibration, SPL level adjustment for different customers, reduced SPL level when the driver is powered from internal battery or for warning / indication signals.

Based on equation (3), with the following parameters given as examples: peak current = 2A; L = 47uH; $C_{piezo}$ = 160nF; the driver is able to generate a voltage $V_{piezo}$ of 34V peak to peak.

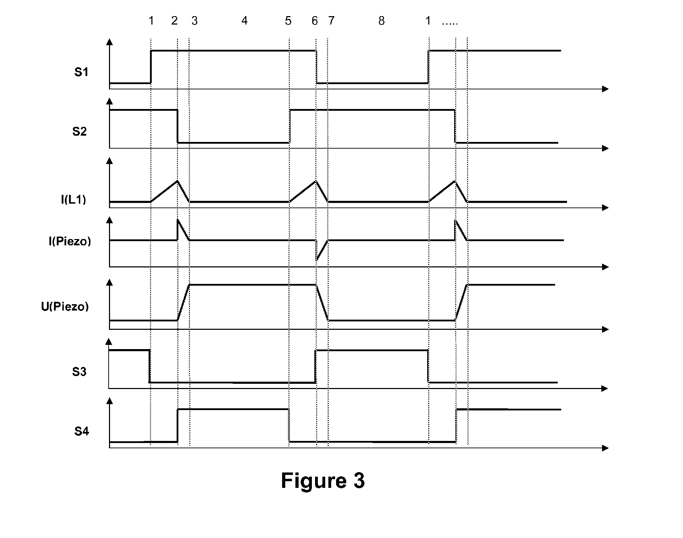

In order to be able to generate sound, the energy transferred to the speaker has to be transferred with opposite direction from one transfer to the other. This will be explained how more in detail with Figure 3.

Referring now to Figure 3, it will be described in more details the different steps of operation of the driver according to the above presented embodiment.

In step 1, both switches S1 and S2 are closed, i.e. switched on, so that the winding current in L1 is rising.

In step 2, when the winding current reaches a threshold level set by the voltage drop in the resistive element R1 and by the comparator reference voltage, switch S2 is opened, i.e. switched off, so that the voltage across the winding becomes positive which causes to close (i.e. switch on) switch S4 and to transfer the energy to the piezoelectric speaker.

In step 3, when energy is transferred, in the given example the piezoelectric voltage is positive.

Step 4 represents a break until the next cycle occurs.

In step 5, switches S1 and S2 are closed (switched on) and the winding current is rising again.

In step 6, when the winding current reaches the threshold level, switch S1 is open (switched off). This time, the voltage across the winding becomes negative which causes to close switch S3 and thus to transfer energy to the speaker.

In step 7, when energy is transferred, the piezoelectric voltage is then negative.

Step 8 represents a break until next cycle corresponding to step 1.

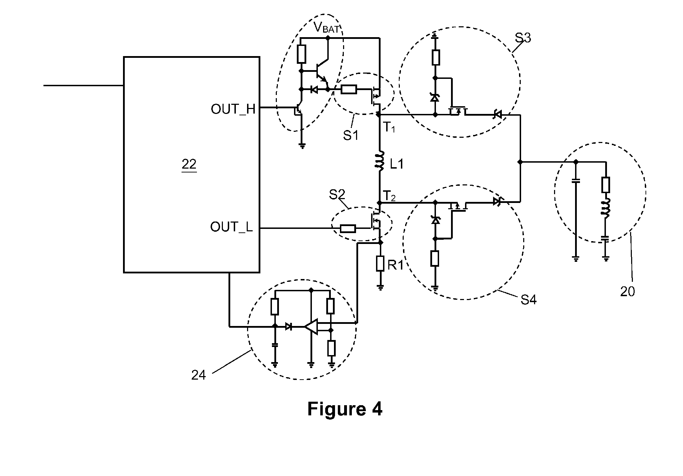

Figure 4 illustrates a detailed electrical schematic of the alarm sounder according to an embodiment of the invention. In this figure, the control circuit sends through OUT_H and OUT_L signals switching commands to the control terminals of switches S1 and S2, which are preferably made in MOS technology. One current terminal of the switch S1 is connected to the supply circuit and the other current terminal is connected to one terminal $T_1$ of the winding. One current terminal of the switch S2 is connected to ground via a resistor R9 and the other current terminal is connected to another terminal $T_2$ of the winding.

The winding terminals $T_1$ and $T_2$ are respectively connected to one current terminal of a switch S3, respectively S4. As explained in relation with Figure 3, the switching off of one switch S1 or S2 will cause the transfer of energy from the winding to the speaker represented with a capacitance. Indeed, when the potential at one current terminal of either switch S3 or switch S4 exceeds the threshold voltage of the transistor of the corresponding switch then the switch is switched on so as to let the energy transfer from the winding to the speaker.

In order to obtain a constant energy level stored in the winding, a comparator has one input connected to the resistive element, while the other input is connected to a comparator reference voltage determining the predefined level of energy that will be stored. The output of the comparator is fed back through the control signals OUT_H and OUT_L.

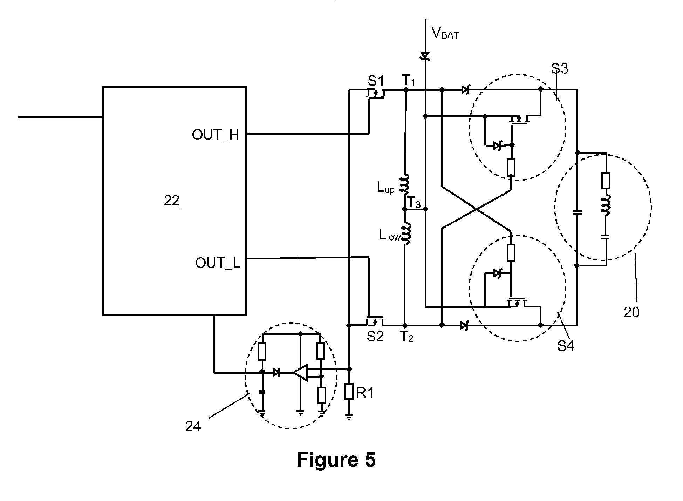

Figure 5 illustrates a detailed electrical schematic of the alarm sounder according to another embodiment. We find again the control circuit which outputs signals OUT H and OUT_L to the control terminals of MOS transistors S1 and S2. One current terminal of S1 is connected to the resistive element while the other current terminal is connected to one side of the winding. One current terminal of S2 is also connected to the resistive element while the other current terminal is connected to the other side of the winding.

In this embodiment, the winding is center-tapped so as to define an upper winding and a lower winding connected in series. With this specific winding configuration, the upper terminal $T_1$ is connected as already mentioned to one current terminal of switch S1 but also to the control terminal of a switch S3, the central terminal $T_3$ is connected to one current terminal of S3 and also to one current terminal of a switch S4 and the lower terminal $T_2$ is connected, as already mentioned to one current terminal of S2, but also to the control terminal of S4.

Thus, after both upper and lower windings have been charged, when one switch, either S1 or S2 is open (i.e. switched off) the corresponding switch S3 or S4 is closed (i.e. switched on) so as to transfer energy from the corresponding winding part, upper or lower, to the piezoelectric speaker.

Having described the invention with regard to certain specific embodiments, it is to be understood that these embodiments are not meant as limitations of the invention. Indeed, various modifications, adaptations and/or combination between embodiments may become apparent to those skilled in the art without departing from the scope of the annexed claims.

**Claims**

1. An alarm sounder comprising a piezoelectric speaker (20) to generate an alarm sound controlled by a driver comprising a control circuit (22) connected to switching means (S1, S2) for alternatively increasing and decreasing energy across a winding (L1) coupled to the piezoelectric speaker, **characterized in that** the driver comprises means for stabilizing the piezoelectric voltage ($U_{piezo}$).

2. An alarm sounder according to claim 1, wherein the means for stabilizing the piezoelectric voltage includes means for limiting (24) the energy stored in the winding to a predefined level and means for transferring (S3, S4) said predefined level of energy directly from the winding (L1) to the piezoelectric speaker (20).

3. An alarm sounder according to claim 2, wherein the limiting means comprises a comparator which monitors the winding current ($I_{L1}$) with a predetermined threshold so as to limit energy storage to the predefined level.

4.  An alarm sounder according to claim 3, wherein one terminal ($T_2$) of the winding is connected to ground through a resistive element (R1) and wherein the predetermined threshold is set by the voltage drop across the resistive element and a comparator reference voltage.

5.  An alarm sounder according to any of claims 2 to 4, wherein the transferring means includes a first (S3), respectively a second (S4), switch connected between one, respectively the other, winding terminal ($T_1$, $T_2$) and a same terminal of the piezoelectric speaker, the other terminal of the piezoelectric speaker being connected to ground, and wherein both switches are alternatively switched on and off so as to transfer with opposite direction said predefined level of energy to the piezoelectric speaker.

6.  An alarm sounder according to any of claims 1 to 5, wherein one winding terminal ($T_1$) is connected to the supply voltage through a third switch (S1) and the other winding terminal ($T_2$) is connected to ground through a fourth switch (S2), the control circuit (22) being adapted for switching on simultaneously both the third and fourth switches to store energy within the winding (L1) and for alternatively switching off one of the two switches when the predefined level of energy is stored so as to transfer energy to the piezoelectric speaker (20).

7.  An alarm sounder according to claim 1 or 2, wherein the driver comprises a couple of windings (I1, L2) connected in series and wherein the common terminal ($T_3$) of both windings is connected to both terminals of the piezoelectric speaker through two switches (S3, S4) and each extreme winding terminal ($T_1$, $T_2$) controls one of the two switches so as to be alternatively switched on and off.

**Figure 1**

**Figure 2**

Figure 3

**Figure 4**

**Figure 5**

Europäisches
Patentamt

European
Patent Office

Office européen
des brevets

# EUROPEAN SEARCH REPORT

Application Number

EP 10 15 2546

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 126 589 A (RENGER HERMAN L [SE]) 30 June 1992 (1992-06-30) <br> * column 1, line 5 - column 3, line 22 * <br> * column 3, line 40 - column 8, line 45 * <br> * claim 1 * <br> ----- | 1-7 | INV. <br> H04R17/00 <br> H01L41/04 <br> G10K7/00 |
| A | GB 2 084 427 A (MOORE PETER; HAMPSHIRE MICHAEL JOHN) 7 April 1982 (1982-04-07) <br> * page 1, line 3 - line 73 * <br> ----- | 1-7 | |
| A | US 2009/038590 A1 (FUKUSHIMA TAKAYUKI [JP]) 12 February 2009 (2009-02-12) <br> * paragraph [0002] - paragraph [0008] * <br> * paragraph [0017] - paragraph [0083] * <br> ----- | 1-7 | |
| A | US 2007/159507 A1 (URANO OSAMU [JP]) 12 July 2007 (2007-07-12) <br> * paragraph [0001] - paragraph [0073] * <br> * paragraph [0104] - paragraph [0318] * <br> ----- | 1-7 | |
| A | US 4 496 914 A (ANDRESEN BERNHARD H [US] ET AL) 29 January 1985 (1985-01-29) <br> * column 1, line 5 - column 3, line 45 * <br> ----- | 1-7 | TECHNICAL FIELDS SEARCHED (IPC) <br><br> H04R <br> H01L <br> G10K <br> G08B |

The present search report has been drawn up for all claims

| Place of search | Date of completion of the search | Examiner |
|---|---|---|
| Munich | 19 March 2010 | Peirs, Karel |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

................................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 10 15 2546

This annex lists the patent family members relating to the patent documents cited in the above-mentioned European search report.
The members are as contained in the European Patent Office EDP file on
The European Patent Office is in no way liable for these particulars which are merely given for the purpose of information.

19-03-2010

| Patent document cited in search report | | Publication date | Patent family member(s) | | Publication date |
|---|---|---|---|---|---|
| US 5126589 | A | 30-06-1992 | AU | 631344 B2 | 19-11-1992 |
| | | | AU | 8144191 A | 05-03-1992 |
| | | | DE | 69104799 D1 | 01-12-1994 |
| | | | DE | 69104799 T2 | 24-05-1995 |
| | | | EP | 0472971 A2 | 04-03-1992 |
| | | | JP | 4262615 A | 18-09-1992 |
| GB 2084427 | A | 07-04-1982 | NONE | | |
| US 2009038590 | A1 | 12-02-2009 | EP | 2022970 A2 | 11-02-2009 |
| | | | JP | 2009041451 A | 26-02-2009 |
| US 2007159507 | A1 | 12-07-2007 | JP | 2007215390 A | 23-08-2007 |
| US 4496914 | A | 29-01-1985 | JP | 58090699 A | 30-05-1983 |

EPO FORM P0459

For more details about this annex : see Official Journal of the European Patent Office, No. 12/82